# EUROPÄISCHE PATENTANMELDUNG

(11) **EP 1 424 882 A1**
(43) Veröffentlichungstag der Anmeldung: **02.06.2004**
(21) Anmeldenummer: 02450268.4
(22) Anmeldetag: 26.11.2002
(51) Int. Cl.: H05K 1/18, H05K 3/04, H01B 7/08

(54) **Flachleiterkabel**

(71) Anmelder: I & T Innovation Technology Entwicklungs- und Holding AG, 7000 Eisenstadt (AT)
(72) Erfinder: John, Wolfgang, Dr., 7000 Eisenstadt (AT)
(74) Vertreter: Patentanwälte BARGER, PISO & PARTNER

(57) **Zusammenfassung**

Die Erfindung betrifft ein Flachleiterkabel (1), insbesondere zur Verwendung in Fahrzeugen, mit zumindest zwei elektrischen Leitern (2) und einer die Leiter umgebenden Isolationsschichte (3) aus Kunststoffmaterial.

Die Erfindung ist dadurch gekennzeichnet, dass elektronische Komponenten (11) auf einem Schaltungslayout (6) auf der Oberfläche des Flachleiterkabels (1) angeordnet und mit zumindest einem Leiter (2) des Flachleiterkabels verbunden sind.

Die Erfindung betrifft auch ein Verfahren zur Herstellung eines derartigen FFC.

## Beschreibung

Die Erfindung betrifft Flachleiterkabel, insbesondere zur Verwendung in Fahrzeugen, mit zumindest zwei elektrischen Leitern und einer die Leiter umgebenden Isolationsschichte aus Kunststoffmaterial.

Derartige Flachleiterkabel sind bekannt und verdrängen in zunehmenden Maße in bauraumkritischen Anwendungen die klassische Rundleiterverkabelung. Insbesondere in der Automobil-Verkabelungstechnik, wo durch die rasch wachsende Anzahl elektronischer Funktionen für Sicherheit und Komfort trotz intelligenter BUS-Technologien der Verkabelungsaufwand stark wächst, kann durch Flachleiterverkabelungen Bauvolumen und insbesondere im Hinblick auf die geplante Verwendung eines 42 V-Bordnetzes und der dann bevorzugt möglichen Reduzierung von Leiterquerschnitten Volumen eingespart werden.

Für die Automobilverkabelung geeignete Flachleiterkabel werden entweder durch Heißlaminieren von zwei kleberbeschichteten, thermoplastischen, Kunststofffolien mit dazwischenliegenden, mit definiertem Abstand zueinander parallel angeordneten Metallbändern hergestellt oder durch Umhüllung von parallel angeordneten Metallbändern mit thermoplastischen Kunststoffen mittels Extrusionsverfahren gefertigt.

In Anlehnung an die Techniken der Leiterplattenherstellung können Flachleiterkabel z. B. auch dadurch hergestellt werden, dass kupferkaschierte Folien endlos mit einer bahnenförmigen Ätzmaske in Form der späteren Leiterbahnen versehen werden und anschließend das nicht benötigte Kupfer im Durchlaufverfahren weggeätzt wird. Anschließend wird über die strukturierten Leiterbahnen entweder eine Isolationsfolie laminiert oder flächig, ggf. mit entsprechenden Aussparungen, ein thermisch oder UV-härtender Abdecklack gedruckt.

Üblicherweise werden die so hergestellten Flachleiterkabel als elektrische Verbindungsstränge verwendet, die mittels lösbarer Steckverbindungen an die jeweiligen elektrischen/elektronischen Komponenten, z. B. Steuergeräte, Stromversorgung, Schalter, Stromverbraucher, etc. angeschlossen werden.

Diese Steckverbindungen, deren Anzahl sich mit zunehmender Ausstattung von Fahrzeugen mit Elektronik und der damit verbundenen Anzahl notwendiger Flachleiterkabeln zwangsläufig erhöht, müssen im Automobilbau hohen Qualitätsstandards hinsichtlich Lebensdauer und elektrischer Zuverlässigkeit unter wechselnden Klima- und Vibrationsbelastungen genügen. Dabei haben sich die Steckverbindungen zunehmend als teuer, voluminös und letzten Endes die Zuverlässigkeit beschränkend herausgestellt.

Ausgehend von diesem Stand der Technik ist es Aufgabe der Erfindung, die Zahl der notwendigen Steckverbindungen zu reduzieren und so ohne Raumverlust zu höherer Zuverlässigkeit zu kommen.

Erfindungsgemäß werden diese Ziele dadurch erreicht, dass elektronische Komponenten auf einem Schaltungslayout direkt auf der Oberfläche des Flachleiterkabels angeordnet und mit zumindest einem Leiter des Flachleiterkabels verbunden sind.

Dazu wird die Kunststoff-Oberfläche des Flachleiters mit einem mit den elektronischen Komponenten bestückbaren Schaltungslayout samt den elektronischen Komponenten versehen (Oberflächenschaltung) und mindestens eine elektrisch leitende Verbindung zwischen den elektronischen Komponenten und mindestens einem Leiter des Flachleiterkabels hergestellt. Die Oberflächenschaltung kann mit aktiven und/oder passiven elektronischen Bauteilen und/oder Sensoren bestückt sein. Sie kann darüber hinaus aber auch als Kontaktfläche für Schalter dienen.

In der Praxis wird dazu auf mindestens einer Seite der elektrisch isolierenden Kunststoffschicht des Flachleiters im Heißprägeverfahren eine Schaltungsstruktur (Leiterbahn) aufgeprägt.

In der EP 0 063 347 A und der DE 198 57 157 A, der Inhalt dieser Druckschriften wird durch Bezugnahme in die vorliegende Beschreibung übernommen, wird die Herstellung einer Kupferfolie beschrieben, die sich in ausgezeichneter Weise zur Verwendung als Schaltungsstruktur für die Erfindung eignet. Kennzeichen dieser galvanisch hergestellten Kupferfolie ist die Ausbildung einer speziellen Gefügestruktur mit geringer Scherfestigkeit. Diese Struktur der Folie erlaubt es, mit einem beheizten Prägestempel, der die Leiterbahnen als erhabene Struktur enthält, die Schaltungsstruktur aus der Folie auszuscheren und gleichzeitig die Leiterbahnen aus Kupfer auf die Kunststoffoberfläche des Flachleiters aufzuprägen.

Diese Prägetechnik ist bereits bekannt und wird beispielsweise zur Herstellung von spritzgegossenen Schaltungsträgern (3-D MID, Molded Interconnect Devices) benutzt und ist ausführlich im Handbuch "Herstellungsverfahren, Gebrauchsanforderungen und Materialkennwerte Räumlicher Elektronischer Baugruppen 3-D MID" , Herausgeber: Forschungsvereinigung Räumliche Elektronische Baugruppen 3-D MID e.V. D-Erlangen, 2.-Auflage, November 1999, Kapitel 9.2.2 beschrieben.

Die Metall-Prägefolie weist vorteilhaft auf der dem zu prägenden Flachleiterkabel zugewandten Seite eine rauhe Struktur, z. B. eine Blumenkohlstruktur (wie in der DE 198 57 157 A beschrieben), auf und ist bevorzugt zusätzlich mit einer Blackoxidbeschichtung versehen. Diese Blackoxidbeschichtung wird mittels Spülen in einem im Stand der Technik für die Behandlung von Leiterplatten gebräuchlichen stromlosen Schwarzoxidationsbad aufgebracht. Dabei kann die in Herrmann, G: "Handbuch der Leiterplattentechnik", Eugen Leuze Verlag, Saulgau/Württ., 1982 beschriebene Technologie verwendet werden. Dieses sogenannte Treatment ergibt nach dem Prägen eine hervorragende Haftung der geprägten Metallstruktur auf thermoplastischen Substraten und zwar dadurch, dass der während des Prägevorganges sich oberflächlich verflüssigende Kunststoff in die Struktur hineinfließt und sich nach dem Erkalten haftfest verankert.

Um eine spätere elektrische Verbindung zwischen der auf die Isolation des Flachleiterkabels aufgeprägten Schaltungsstruktur und wenigstens einem Leiter herstellen zu können, wird vor dem Aufprägen zumindest eine, meist aber mehrere, Fensteröffnung in der Isolationsschicht des Flachleiters angebracht. Dazu können z. B. CO₂-Lasersysteme verwendet werden, die den isolierenden Kunststoff über den Flachleiterbahnen definiert wegbrennen. Ebenso ist es auch möglich, durch mechanische Abtragsverfahren, wie z. B. Schaben, die Isolation zu entfernen.

Zur Ausbildung des erfindungsgemäßen, mit einer Oberflächen-Schaltungsstruktur versehenen Flachleiters wird das Schaltungslayout so entworfen, respektive die Prägekontur im Prägestempel so herausgearbeitet, dass das Ende einer Leiterbahn oder eine beliebige, innerhalb einer Leiterbahn befindliche, Stelle über die vorher erzeugten Fenster geprägt werden kann.

Im nächsten Schritt wird mittels beheiztem Prägestempel und unter Anwendung von Druck aus einer handelsüblichen Kupferfolie, vorzugsweise einer Dicke zwischen 12 und 120 µm, die auf der Prägeseite das beschriebene Treatment besitzt, das Leiterbild ausgeschert und gleichzeitig auf die Isolation des Flachleiters geprägt. Die Temperatur- und Druckbedingungen hängen dabei von der Art und Dicke des Kunststoffisolationsmaterials des Flachleiters, der Größe des zu prägenden Schaltungslayouts und der Dicke der zu prägenden Leiterbahnstruktur ab. Die Dicke der zum Prägen benutzte Folie ist wiederum abhängig von der gewünschten Stromtragfähigkeit der später auf dem Flachleiter aufgebauten elektronischen Schaltung.

An den Stellen des Flachleiters, an denen zuvor Fenster in der Isolation angebracht wurden und über die das Layout geprägt wird, liegt die Folie nach dem Prägen frei über den Leiterbahnen des Flachleiters, da sich unter diesen Stellen ja kein Kunststoff befindet. Das Leiterbahnlayout ist an den Stellen jedoch so gestaltet, dass um die Isolationsfenster herum ein Rand, vorzugsweise in einer Breite von 0,5 geprägt wird.

Wenn auf der anderen Seite des Flachleiters, also an der Unterseite der Stellen, die für die Verbindung der Oberflachenschaltung mit den Leitern des Flachleiters vorgesehen sind, die Isolation ebenfalls geöffnet wird, kann die Verbindung überraschenderweise durch Widerstandsschweißen erfolgen, indem von einer Schweißelektrode der Flachleiter und von der anderen Schweißelektrode die geprägte Leiterbahn berührt wird. Durch Zusammenpressen der Elektroden und Beaufschlagung mit einem Stromimpuls erfolgt nun die elektrische Verbindung durch Ausbildung einer Schweißverbindung.

In einer Ausgestaltung der Erfindung können die geprägten Schaltungslayouts auch unmittelbar neben Isolationsfenster geprägt werden, um anschließend über Drahtbondtechniken die elektrische Verbindung zwischen geprägtem Schaltungslayout und den Leiterbahnen im Flachleiter herzustellen. In Abhängigkeit von der Drahtbondtechnik kann es dann erforderlich sein, sowohl die Oberfläche der geprägten Leiterbahnen, vorzugsweise in den Bereichen, in denen gebondet werden soll, als auch die Oberflächen der durch Fenster in der Isolation des Flachleiters freigelegten Leiterbahnen durch an sich bekannte chemische oder elektrochemische Methoden zu veredeln.

Insbesondere nach dem Bonden, aber fallweise auch nach dem Schweißen der Verbindungen, können diese Stellen z. B. im freien Verguß bzw. durch Dispensen mit einem thermisch, chemisch oder UV-härtbarem Vergußharz, dessen chemische Struktur eine ausgezeichnete Haftfestigkeit zum Isolationsmaterial des Flachleiters gewährleisten sollte, vor Umwelteinflüssen geschützt werden.

Das Flachleiterkabel, welches nun mit einer Oberflächen-Leiterbahnstruktur ausgestattet ist, die elektrisch leitende Verbindungen zu den Leiterbahnen im Flachleiter enthält, kann nun mit elektronischen Bauteilen bestückt werden. Da die für die Herstellung von Flachleitern benutzten thermoplastischen Isolationsmaterialien in der Regel übliche Reflow-Löttemperaturen nicht schadlos überstehen, bieten sich zur Bestückung selektive Lötverfahren, wie z. B. Laserlöten oder Lichtlöten an. Ebenso ist aber auch eine Verbindungstechnik über Leitkleben oder niedrigschmelzende Lote möglich.

Die fertig bestückten Flachleiterkabel können zum Schutz vor äußeren Einflüssen im Bereich der Schaltungen durch z.B. Gehäuseschalen oder durch selektiven Verguß oder mit einem Überzug aus Schutzlack versehen werden.

Dabei ist es möglich, am bzw. im Gehäuse ebenfalls elektronische Bauteile oder auch Stecker, Schalter, od.dergl. anzuordnen und so die Integration der Verkabelung weiter voranzutreiben.

Die Erfindung wird im Folgenden anhand der Zeichnung näher erläutert. Dabei zeigt
die Fig. 1 eine Draufsicht auf und einen Schnitt durch einen FFC mit Fenstern,
die Fig. 2 Draufsicht und Schnitt gemäß Fig. 1 nach dem Aufbringen einer geprägten Leiterbildstruktur,
die Fig. 3 einen Schnitt entlang der Linie III-III der Fig. 2, allerdings mit aufgesetztem Prägestempel,
die Fig. 4 eine Variante in Draufsicht und Schnitt analog zur Fig. 2,
die Fig. 5 in zwei Darstellungen das Detail V der Fig. 2 wobei Fig. 5a die Herstellung und Fig. 5b die fertige Verbindung zeigt,
die Fig. 6 das Detail VI der Fig. 4 in einer Ansicht ähnlich der der Fig. 5b,
die Fig. 7 eine Variante des mechanischen Schutzes einer Bondstelle gemäß Fig. 6,
die Fig. 8 den Flachleiter gemäß Fig. 2 bzw. Fig. 4 bestückt mit den elektronischen Bauteilen,
die Fig. 9 den Flachleiter der Fig. 8 in Seitenansicht, versehen mit einem mechanischen Schutzgehäuse,
die Fig. 10 den Flachleiter ähnlich der Fig. 9 allerdings mit freiem Verguß gemäß Fig. 10a oder Formverguß gemäß Fig. 10b,
die Fig. 11 eine Variante der Erfindung bei der eine bestückte Leiterplatte auf den Flachleiter aufgesetzt ist,
die Fig. 12 als Beispiel einer Kontaktierungsmöglichkeit der Variante gemäß Fig. 11 die Herstellung eines Kontaktes mittels Widerstandsschweißung,
die Fig. 13 schematisch, die Ausbildung eines Tasters auf einem FFC und
die Fig. 14 eine schematische Ausbildung eines Schalters auf einem FFC.

Es werden in der folgenden Beschreibung die Leiterbahnen des FFC's als "Leiter 2" bezeichnet, um sie von den erfindungsgemäß auf der Isolierschicht aufgebrachten "Leiterbahnen 6" semantisch zu unterscheiden. In den Figuren wurde aus Gründen der Übersichtlichkeit von Schraffuren und "vorschriftsmäßigen Schnitten abgesehen, die Darstellungen sind rein schematisch.

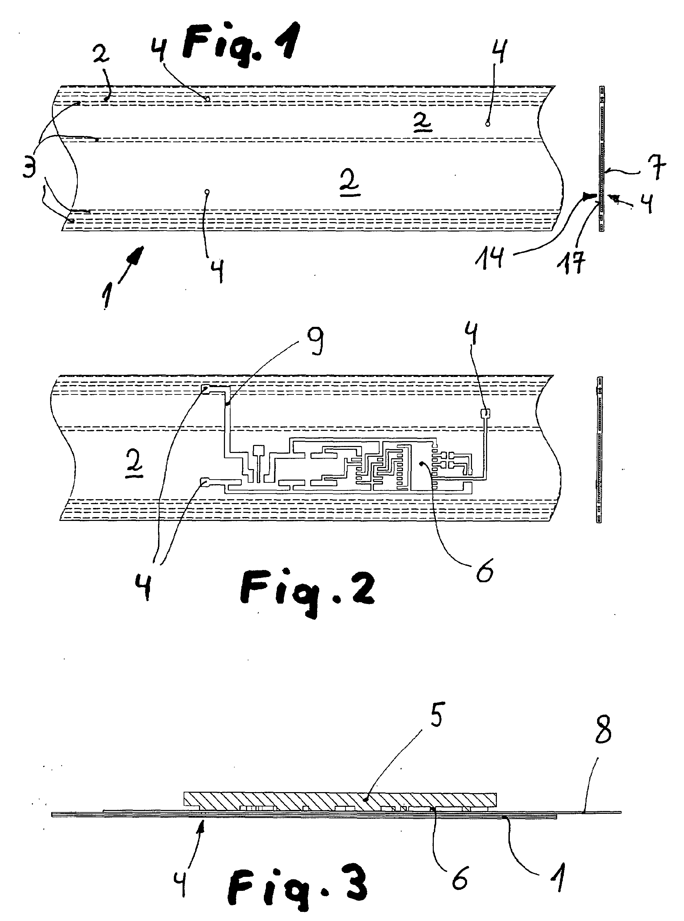

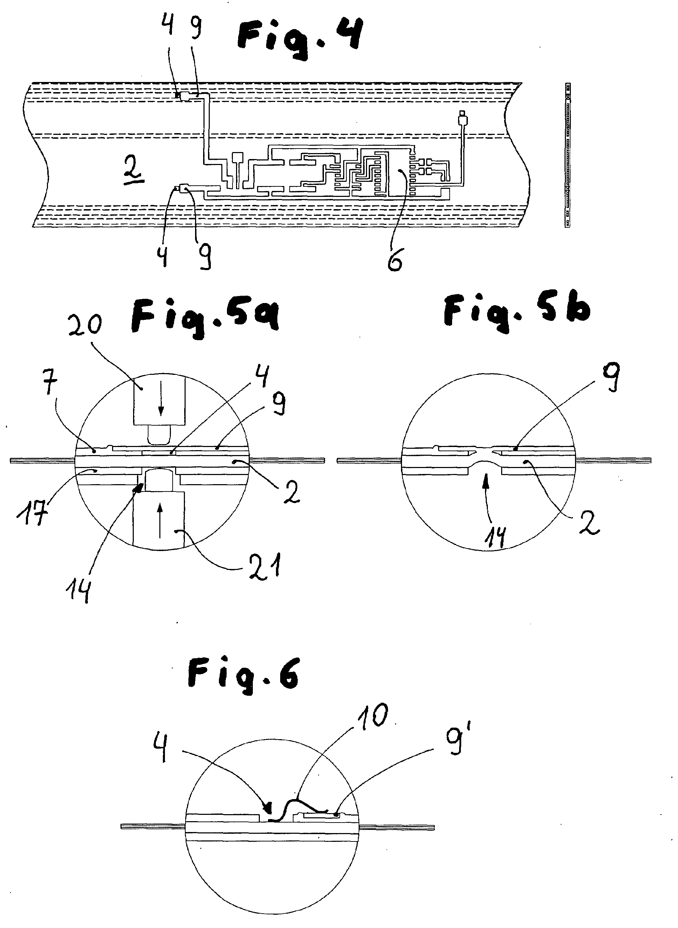

Wie aus Fig. 1 ersichtlich ist, werden in einem FFC 1 im Bereich von dessen Leiter 2, die durch Abstände 3 voneinander getrennt sind, Fenster 4 in der Isolierung angebracht. Diese Fenster 4 werden in einer ersten Variante fluchtend sowohl in der oberen Isolierschicht 7 als auch in der unteren Isolierschicht 17 vorgesehen, um den entsprechenden Leiter 2 passend freizulegen.

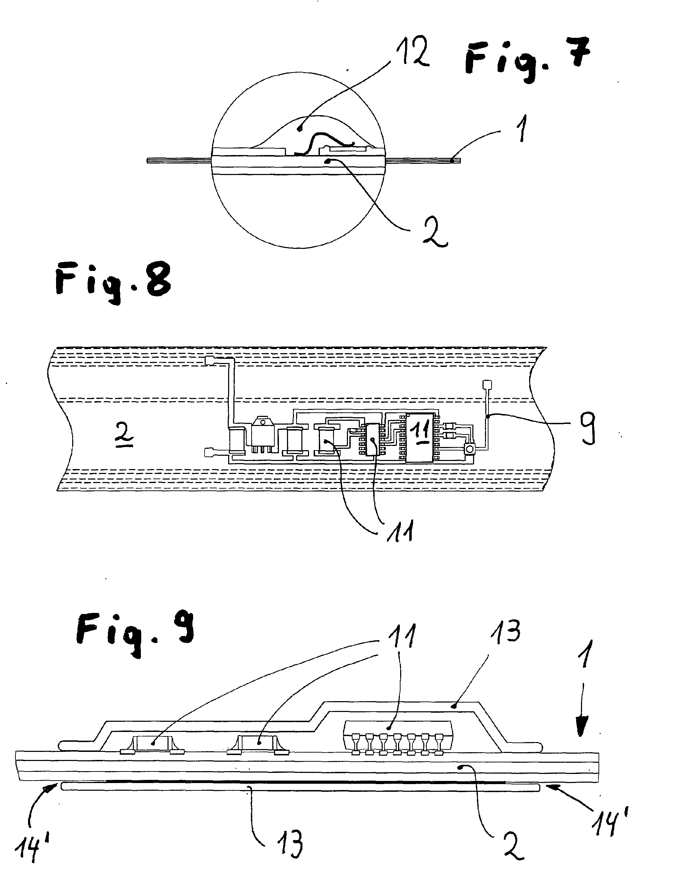

Wie aus Fig. 2 und 3 im Zusammenhalt ersichtlich ist, wird sodann mit einem beheizten Prägestempel 5, der die gewünschte Kontur der Leiterbahnen 6 erhaben trägt, durch Aufsetzen und Anpressen die Leiterbildstruktur von einer zwischen dem Stempel 5 und der oberen Isolierschicht 7 eingeschobenen Prägefolie 8 auf die obere Isolierschicht 7 übertragen.

Dabei kann, wie in Fig. 2 dargestellt, die Leiterbahn 6 über die Fenster 4 geführt werden was eine direkte Kontaktierung zwischen der Leiterbahnstruktur 9 und den Leitern 2 des FFC erlaubt, was aber im Bereich jedes Fensters 4, in dem die Leiterbahn 6 "freifliegend" aufgebracht werden muss, zu mechanischen Problemen beim Aufbringen führen kann, oder es wird, wie in Fig. 4 und Fig. 6 ersichtlich, die Leiterbahnstruktur 9 bis nahe zu den Fenstern 4 geführt und dann jeweils mit einem sogenannten Drahtbond 10 die elektrische Verbindung mit den Leitern 2 hergestellt.

Wie insbesondere aus Fig. 6 hervorgeht, erlaubt es die Verbindung mittels Drahtbonden, die Fenster 4 nur einseitig anzubringen, während bei der direkten Verbindung, die bevorzugt über Widerstandsschweißen (Fig. 5a) erfolgt, der Leiter 2 auch von der Unterseite her mittels eines Fensters 14 in der unteren Isolierschicht 17 zugänglich sein muss, um der Elektrode des Schweißgerätes den Kontakt mit dem Leiter 2 zu ermöglichen.

Zum Schutz des Verbindungsbereiches rund um die Fenster 4, 14 wird bevorzugt Vergussharz verwendet, dies ist in Fig. 7 anhand eines Beispieles mit einer Verbindung mittels Drahtbond dargestellt, für den Fachmann ist klar ersichtlich, wie er bei der direkten Verbindung zwischen dem Leiter2 und der Leiterbahn 6 gemäß Fig. 5b vorzugehen hat, und Es werden in der folgenden Beschreibung die Leiterbahnen des FFC's als "Leiter 2" bezeichnet, um sie von den erfindungsgemäß auf der Isolierschicht aufgebrachten "Leiterbahnen 6" semantisch zu unterscheiden. In den Figuren wurde aus Gründen der Übersichtlichkeit von Schraffuren und "vorschriftsmäßigen Schnitten abgesehen, die Darstellungen sind rein schematisch.

Wie aus Fig. 1 ersichtlich ist, werden in einem FFC 1 im Bereich von dessen Leiter 2, die durch Abstände 3 voneinander getrennt sind, Fenster 4 in der Isolierung angebracht. Diese Fenster 4 werden in einer ersten Variante fluchtend sowohl in der oberen Isolierschicht 7 als auch in der unteren Isolierschicht 17 vorgesehen, um den entsprechenden Leiter 2 passend freizulegen.

Wie aus Fig. 2 und 3 im Zusammenhalt ersichtlich ist, wird sodann mit einem beheizten Prägestempel 5, der die gewünschte Kontur der Leiterbahnen 6 erhaben trägt, durch Aufsetzen und Anpressen die Leiterbildstruktur von einer zwischen dem Stempel 5 und der oberen Isolierschicht 7 eingeschobenen Prägefolie 8 auf die obere Isolierschicht 7 übertragen.

Dabei kann, wie in Fig. 2 dargestellt, die Leiterbahn 6 über die Fenster 4 geführt werden was eine direkte Kontaktierung zwischen der Leiterbahnstruktur 9 und den Leitern 2 des FFC erlaubt, was aber im Bereich jedes Fensters 4, in dem die Leiterbahn 6 "freifliegend" aufgebracht werden muss, zu mechanischen Problemen beim Aufbringen führen kann, oder es wird, wie in Fig. 4 und Fig. 6 ersichtlich, die Leiterbahnstruktur 9 bis nahe zu den Fenstern 4 geführt und dann jeweils mit einem sogenannten Drahtbond 10 die elektrische Verbindung mit den Leitern 2 hergestellt.

Wie insbesondere aus Fig. 6 hervorgeht, erlaubt es die Verbindung mittels Drahtbonden, die Fenster 4 nur einseitig anzubringen, während bei der direkten Verbindung, die bevorzugt über Widerstandsschweißen (Fig. 5a) erfolgt, der Leiter 2 auch von der Unterseite her mittels eines Fensters 14 in der unteren Isolierschicht 17 zugänglich sein muss, um der Elektrode des Schweißgerätes den Kontakt mit dem Leiter 2 zu ermöglichen.

Zum Schutz des Verbindungsbereiches rund um die Fenster 4, 14 wird bevorzugt Vergussharz verwendet, dies ist in Fig. 7 anhand eines Beispieles mit einer Verbindung mittels Drahtbond dargestellt, für den Fachmann ist klar ersichtlich, wie er bei der direkten Verbindung zwischen dem Leiter2 und der Leiterbahn 6 gemäß Fig. 5b vorzugehen hat, und stellt keine Schwierigkeit für ihn dar, weshalb hier darauf verzichtet wird, näher auf diese Variante einzugehen.

In der Folge kann der FFC mittels der üblichen Bestückungsautomaten mit diskreten elektronischen Bauteilen bestückt werden, wie dies beispielshaft aus Fig. 8 hervorgeht. Die einzelnen elektronischen Bauteile 11 werden passend aufgelegt bzw. aufgeklebt.

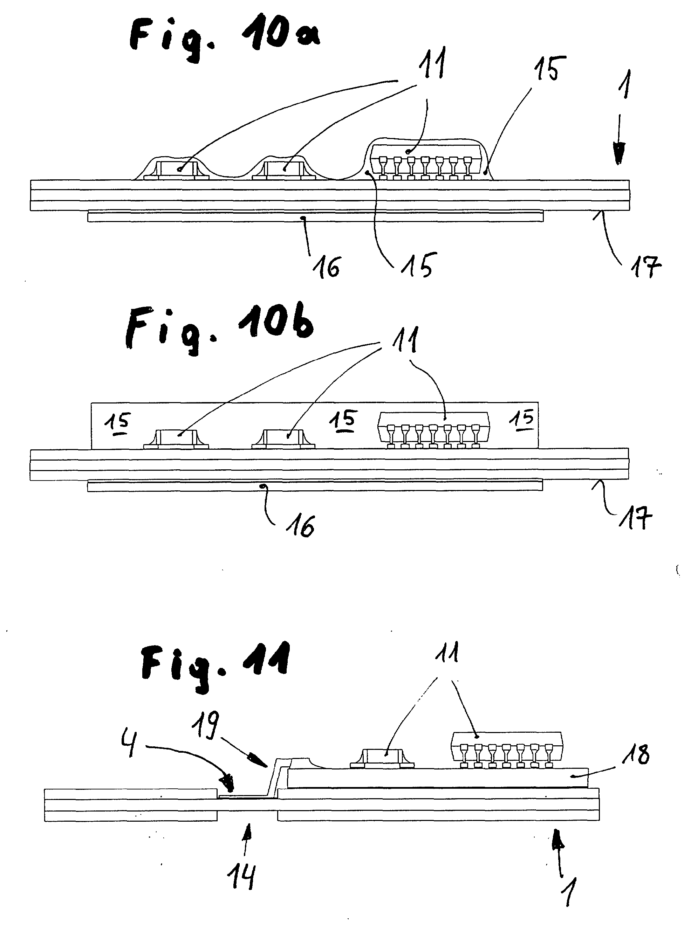

Aus Fig. 9 geht eine mögliche Abdeckung die elektronischen Bauteile 11 zum Schutz der Bauteile vor mechanischer Beschädigung bzw. auch gegebenenfalls auch zur Abschirmung gegenüber elektromagnetischen Einflüssen hervor. Eine steife oder auch bedingt flexible Abdeckung 13 deren Geometrie der jeweils abzudeckenden elektronischen Schaltung angepasst ist, wird entweder einstückig mit einem scharnierartigen Gelenk sowohl oberhalb als auch unterhalb des FFC1 an passender Stelle aufgeschoben und beispielsweise durch Klipse oder hackenförmige Elemente geschlossen, worauf die endgültige Fixierung gegebenenfalls durch Klebstoff, der zugleich eine Abdichtfunktion gegen das Eindringen von Feuchtigkeit übernimmt an den Rand stellen und im Kontaktbereich mit dem FFC1 übernimmt. Die Anordnung solcher Klebe- bzw. Dichtmassen ist mit 14' angedeutet, die Gehäuseschale (ohne Schraffur, aber im schematischen Schnitt" 13 einstückig zu denken.

Selbstverständlich ist es möglich und gegebenenfalls für die Herstellung und auch Montage derartige Gehäuse günstiger das Gehäuse zweiteilig auszubilden und einen im wesentlichen ebenen unteren Teil mit dem oberen Teil 13 beispielsweise durch pilzförmige Vorsprünge die in entsprechende Ausnehmungen des Gegenteiles gedrückt werden und dort entweder durch Reibschluss oder durch elastische Deformation fixiert werden, herzustellen. Auch in diesem Fall kann durch Einbringen von Klebstoff bzw. Dichtmasse die Fixierung und Abdichtung gegenüber dem FFC1 erfolgen, die Abdichtung zwischen den beiden Gehäuseteilen kann bevorzugt durch die gleichen Materialien in einem Arbeitsgang erfolgen. Wenn am FFC genügend Platz ist kann selbstverständlich die Fixierung der Gehäuseschale 13 durch eine lochförmige Ausnehmung am FFC bewerkstelligt werden, doch wird man im Allgemeinen davon ausgehen müssen, dass dafür im FFC nicht ausreichend Platz zwischen den aktiven Leiterbahnen 2 zur Verfügung stehen wird.

Die Fig. 10 zeigt in zwei Ansichten die Verwendung von Vergussmasse statt eines Gehäuses, dabei zeigt die Fig. 10a den Verguss in sogenannter freier Form, während die Fig. 10b einen sogenannten Formverguss zeigt. Der Unterschied ist dem Fachmann auf dem Gebiete der elektronischen Bauteile bekannt und bedarf so wie die verwendeten Vergussmassen die vom Fachmann in Kenntnis der Erfindung je nach Aufgabengebiet und Anwendungsgebiet leicht ausgesucht werden können hier keine weitere Erläuterung. Darauf hingewiesen werden soll nur, dass statt des Unterteils des Gehäuses eine Stabilisierungsplatte verwendet wird, die passend an der unteren Oberfläche 17 des FFC1 fixiert wird, dies kann durch Klebstoff oder ein doppelseitiges Klebeband erfolgen.

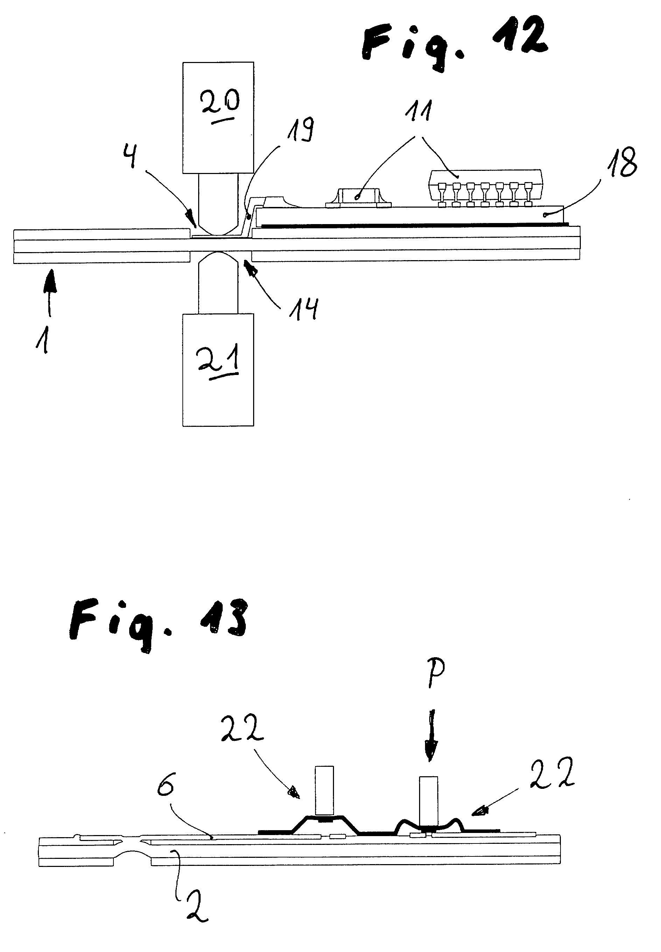

Die Fig. 11 schließlich zeigt eine Variante, die insbesondere bei komplexeren elektronischen Schaltkreisen 11 angeraten sein kann und auch dann wenn für eine benötigte Schaltung bereits eine fertige Lösung auf einer üblichen Schalterplatte besteht. Das ist in diesem Fall eine elektronische Schaltung 11 auf der Leiterplatte 18 fertig angeordnet, es wird sodann nur eine Leiterplatte 18 passend am FFC1 verklebt wobei darauf zu achten ist, dass die Anschlusselemente 19 der Leiterplatte 18 passend mit den Fenstern 4 des FFC1 zu liegen kommen. In der Folge, wie in Fig. 12 schematisch gezeigt, kann durch Widerstandsschweißen mit Schweißelektroden 20,21 die elektrische und mechanische Verbindung hergestellt werden und darauf kann, nicht dargestellt, ein mechanischer Schutz der Verbindung beispielsweise durch Vergussharz analog zu der in Fig. 7 dargestellten Situation aufgebracht werden.

Selbstverständlich ist es möglich in der Folge auch die auf der Leiterplatte 18 angebrachte Schaltung 11 durch eine Abdeckung oder durch Vergussharz analog zu den Varianten der Fig. 9 und 10 mechanisch zu schützen, dies kann der Fachmann in Kenntnis der Erfindung jederzeit selbst festlegen.

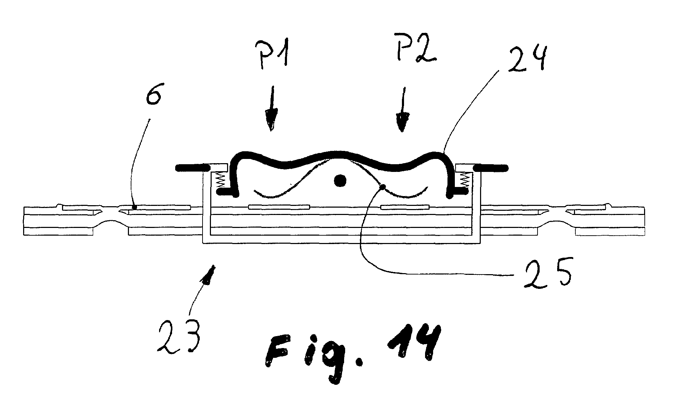

Die Fig. 13 ist ein Beispiel dafür dargestellt, dass es möglich ist beispielsweise einen Taster auf einfachste Weise direkt auf einem FFC1 zu montieren. Es muss dazu nur auf den aufgeprägten Leiterbahnen 6 ein passender elastisch ausgebildeter Taster 22 befestigt werden, dies kann beispielsweise durch ein handelsübliches Gummischaltelement 7 realisiert werden, dass beim Ausüben eines Druckes e einen leitenden Teil seines Stößels so gegen zwei benachbarte und ansonsten elektrisch voneinander getrennte Leiterbahnbereich 6 drückt, dass dadurch eine elektrische Verbindung geschaffen wird.

Die Fig. 14 schließlich zeigt die Anordnung eines Schaltes in einem regelrechten, den FFC1 übergreifenden Gehäuse. Der Schalter 23 selbst ist an sich herkömmlich, aber an den Verwendungszweck angepasst, aufgebaut und besteht aus einer Wippe 24, durch die eine leitende Kontaktbrücke 25 zwischen zwei verschiedenen Positionen verschwenkt werden kann, wobei je nach Position zwei Abschnitte der Leiterbahnen 6 miteinander elektrisch verbunden oder voneinander getrennt werden.

Die Erfindung ist nicht auf die dargestellten und beschriebenen Beispiele beschränkt sondern kann verschiedentlich abgewandelt werden. So ist es möglich statt der Leiterplatte 18 die in letzter Zeit insbesondere im Automobilbau vielfach verwendeten elastischen Leiterfolien zu verwenden, wodurch einerseits eine getrennte Herstellung von FFC möglich wird, andererseits die erfindungsgemäßen Vorteile der direkten Kontaktierung und des geringen Platzbedarfes und auch der beibehaltenen mechanischen Deformierbarkeit erhalten werden.

Varianten sind auch bei den Kontaktierungen möglich, hier ist neben dem Widerstandsschweissen auch das Leitkleben aber auch andere Techniken vorstellbar. Es liegt die Erfindung grundsätzlich in der Idee den FFC1 direkt oder indirekt als Träger für aktiver oder passiver elektronische oder Schaltelemente heranzuziehen, aus dieser Grundidee sind die Durchführung und Ausgestaltung betreffenden Lösungen der mechanischen und elektrischen Verbindungen, der Abdeckungen bzw. des Vergießens weniger bedeutenden Aspekte der Erfindung.

## Patentansprüche

1. Flachleiterkabel, insbesondere zur Verwendung in Fahrzeugen, mit zumindest zwei elektrischen Leitern (2) und einer die Leiter umgebenden Isolationsschichte (3) aus Kunststoffmaterial, **dadurch gekennzeichnet, dass** elektronische Komponenten (11) auf einem Schaltungslayout (6) auf der Oberfläche des Flachleiterkabels (1) angeordnet und mit zumindest einem Leiter (2) des Flachleiterkabels verbunden sind.

2. Flachleiterkabel nach Anspruch 1, **dadurch gekennzeichnet, dass** das Schaltungslayout (6) eine Kupferfolie mit geringer Scherfestigkeit ist.

3. Flachleiterkabel nach Anspruch 1 oder 2, **dadurch gekennzeichnet, dass** die elektronischen Komponenten (11) durch Leitkleben mit dem Schaltungslayout (6) verbunden sind.

4. Flachleiterkabel nach einem der Ansprüche 1 bis 3, **dadurch gekennzeichnet, dass** die elektronischen Komponenten (11) durch Gehäuseschalen (13) oder durch selektiven Verguß (15) oder mit einem Schutzlack, beispielsweise aus einem aushärtbarem Polymersystem bestehend, abgedeckt sind.

5. Flachleiterkabel nach einem der voranstehenden Ansprüche, **dadurch gekennzeichnet, dass** die Kupferfolie auf der dem Flachleiterkabel zugewandten Seite eine Blumenkohlstruktur aufweist und mit einer Blackoxidbeschichtung versehen ist.

6. Flachleiterkabel nach einem der voranstehenden Ansprüche, **dadurch gekennzeichnet, dass** die elektrisch leitende Verbindung zwischen dem Schaltungslayout (6, 9) und der zumindest einen Leiterbahn (2) des Flachleiters durch Widerstandsschweißen erfolgt.

7. Verfahren zur Herstellung eines Flachleiterkabel nach einem der Ansprüche 1 bis 6, **dadurch gekennzeichnet, dass**
in die Oberfläche des Flachleiters zumindest eine fensterartige Öffnung (4, 14) in der thermoplastischen Isolationsschicht (3) geschaffen wird, dass
eine metallische Leiterbahnstruktur, bevorzugt aus Kupfer, als Schaltungslayout (6, 9) auf die thermoplastische Isolationsschicht (3) aufgeprägt wird, dass
die elektronischen Bauteile (11) auf das Schaltungslayout (6, 9) aufgebracht werden und dass
das Schaltungslayout (6, 9) mit zumindest einem Leiter (2) des Flachleiterkabels (1) elektrisch leitend verbunden wird.

8. Verfahren nach Anspruch 7, **dadurch gekennzeichnet, dass** die Herstellung der fensterartigen Öffnungen (4, 14) durch Abtragen der thermoplastischen Isolierschicht (3) mittels Laser geschaffen werden.

9. Verfahren nach Anspruch 7 oder 8, **dadurch gekennzeichnet, dass** das Schaltungslayout (6, 9) die zumindest eine fensterartige Öffnung (4) zumindest teilweise überdeckt und die elektrisch leitende Verbindung des Schaltungslayouts mit dem Leiter (2) des Flachleiterkabel direkt erfolgt.

10. Verfahren nach Anspruch 9, **dadurch gekennzeichnet, dass** die fensterartige Öffnung (4, 14) zu beiden Seiten (7, 17) des Flachleiterkabels (1) vorgesehen ist und dass die elektrisch leitende Verbindung durch Widerstandschweißen erfolgt.

11. Verfahren nach Anspruch 7 oder 8, **dadurch gekennzeichnet, dass** das Schaltungslayout neben einer Fensteröffnung angeordnet ist und dass die elektrische Verbindung zwischen dem Schaltungslayout und dem Leiter des Flachleiters mittels Drahtbondtechniken erfolgt.

12. Verfahren nach einem der Ansprüche 7 bis 11, **dadurch gekennzeichnet, dass** über dem Bereich des Flachleiterkabel, in dem sich der Schaltungslayout (6, 9) mit den elektronischen Bauteilen (11) befindet, ein Gehäuse (13) montiert oder eine Vergußmasse (15) oder ein Überzug aus Schutzlack aufgebracht wird.
